# EUROPEAN PATENT SPECIFICATION

(11) **EP 4 220 734 B1**
(45) Date of publication and mention of the grant of the patent: **20.11.2024**
(21) Application number: 23152421.6
(22) Date of filing: 19.01.2023
(51) Int. Cl.: H01L 29/51, H01L 29/16, H01L 21/04, H01L 21/28, H01L 29/20, H01L 29/778, H01L 29/78

(54) **WIDE BAND GAP TRANSISTOR WITH NANOLAMINATED INSULATING GATE STRUTCTURE AND PROCESS FOR MANUFACTURING A WIDE BAND GAP TRANSISTOR**
TRANSISTOR MIT BREITER BANDLÜCKE MIT NANOLAMINIERTER ISOLIERENDER GATE-STRUKTUR UND VERFAHREN ZUR HERSTELLUNG EINES TRANSISTORS MIT BREITER BANDLÜCKE
TRANSISTOR À LARGE BANDE INTERDITE À STRUCTURE DE GRILLE ISOLANTE NANOSTRATIFIÉE ET PROCÉDÉ DE FABRICATION D'UN TRANSISTOR À LARGE BANDE INTERDITE

(30) Priority: 28.01.2022 IT 202200001478
(43) Date of publication of application: 02.08.2023
(73) Proprietor: STMicroelectronics S.r.l., 20864 Agrate Brianza (MB) (IT)
(72) Inventor: IUCOLANO, Ferdinando, 95030 Gravina di Catania (CT) (IT); LO NIGRO, Raffaella, 95030 Sant'Agata Li Battiati (CT) (IT); SCHILIRO', Emanuela, 95034 Bronte (CT) (IT); ROCCAFORTE, Fabrizio, 95030 Mascalucia (CT) (IT)
(74) Representative: Studio Torta S.p.A.

(56) References cited:
- CAO DUO ET AL: "Interfacial and electrical characteristics of tetragonal HfO2/Al2O3 multilayer grown on AlGaN/GaN", JOURNAL OF MATERIALS SCIENCE: MATERIALS IN ELECTRONICS, CHAPMAN AND HALL, LONDON, GB, vol. 29, no. 9, 10 February 2018 (2018-02-10), pages 7644 - 7650, XP037126608, ISSN: 0957-4522, [retrieved on 20180210], DOI: 10.1007/S10854-018-8757-1
- BONGMOOK LEE ET AL: "Performance enhancement of AlGaN/GaN metal-oxide-semiconductor heterojunction field-effect transistor (MOSHFET) with atomic layer deposition (ALD) of high-k HfAlO gate dielectric layer", SEMICONDUCTOR DEVICE RESEARCH SYMPOSIUM (ISDRS), 2011 INTERNATIONAL, IEEE, 7 December 2011 (2011-12-07), pages 1 - 2, XP032097291, ISBN: 978-1-4577-1755-0, DOI: 10.1109/ISDRS.2011.6135162
- QINGWEN SONG ET AL: "Atomic layer deposited high-HfAlO as an alternative gate dielectric for 4H-SiC MIS based transistors", SCIENCE CHINA TECHNOLOGICAL SCIENCES, SP SCIENCE CHINA PRESS, HEIDELBERG, vol. 55, no. 3, 28 December 2011 (2011-12-28), pages 606 - 609, XP035018598, ISSN: 1869-1900, DOI: 10.1007/S11431-011-4697-1
- LIU XINKE ET AL: "Impact of In situ vacuum anneal and SiH4 treatment on electrical characteristics of AlGaN/GaN metal-oxide-semiconductor high-electron mobility transistors", APPLIED PHYSICS LETTERS, AMERICAN INSTITUTE OF PHYSICS, 2 HUNTINGTON QUADRANGLE, MELVILLE, NY 11747, vol. 99, no. 9, 29 August 2011 (2011-08-29), pages 93504 - 93504, XP012153851, ISSN: 0003-6951, [retrieved on 20110901], DOI: 10.1063/1.3633104

## Description

The present invention relates to a wide band gap transistor with nanolaminated insulating gate structure and to a process for manufacturing a wide band gap transistor.

As is known, semiconductor materials, which have a Wide Band Gap (WBG), in particular, which have an energy value Eg of the band gap being greater than 1.1 eV, low on-state resistance (RON), a high value of thermal conductivity, high operating frequency and high saturation velocity of charge carriers, are particularly suitable for producing electronic components for power applications, such as MOSFET, JFET, HEMT (High Electron Mobility Transistors) and MISHEMT (Metal-Insulator-Semiconductor High Electron-Mobility Transistors).

A material having similar characteristics, and designed to be used for manufacturing electronic components, is silicon carbide (SiC) in its different polytypes (for example, 3C-SiC, 4H-SiC, 6H-SiC).

Another example of material which is advantageously exploited for this purpose is gallium nitride (GaN). For example, high-mobility field-effect transistors are known based on the formation of layers of two-dimensional electron gas (2DEG) with high mobility at a heterojunction, that is at the interface between semiconductor materials having different band gap. For example, HEMT transistors are known based on the heterojunction between a layer of aluminum gallium nitride (AlGaN) and a layer of gallium nitride (GaN).

In power transistors made of SiC or GaN, using high-permittivity dielectrics is advantageous to form insulating gate structures. In fact, these materials allow both the electric field inside the insulating gate structures and the on-state resistance RON of the devices to be reduced and, in addition, also entail benefits for the threshold voltage.

The publication "Interfacial and electrical characteristics of tetragonal HfO2/Al2O3 multilayer grown on AlGaN/GaN" by Duo Cao et al. published in Journal of Materials Science: Materials in Electronics, Springer, Germany, vol. 29, no. 9, in May 2018, discloses a wide band gap transistor, comprising: a semiconductor structure, including at least one wide band gap semiconductor layer of gallium nitride (GaN); an insulating gate structure; a gate electrode, separated from the semiconductor structure by the insulating gate structure; wherein the insulating gate structure contains a mixture of aluminum, hafnium and oxygen; and wherein in the HAOM insulating gate structure film, the Al₂O₃ layers remain amorphous, while the HfO₂ layers have fully crystallized.

A problem of high-permittivity materials currently used is linked to the tendency to deteriorate when exposed to high temperatures. In particular, at temperatures commonly reached in some steps of the manufacturing of wide band gap devices, pure high-permittivity materials tend to crystallize and the phase change may lead to an increase in the leakage currents of the devices. For example, the formation of ohmic contacts typically requires high-temperature annealing steps and may cause the crystallization of the high-permittivity dielectrics. Consequently, the process flow has to be organized so as to perform the steps that require high temperatures before forming the insulating gate structures. However, this process sequence may require additional steps otherwise unnecessary which entail an increase in production costs. For example, an additional photolithography needs to be performed to define the ohmic contacts separately from the insulating gate structure.

On the other hand, materials such as silicon oxide tolerate even very high temperatures without degrading, but do not have sufficient permittivity to achieve the high performances often required.

The aim of the present invention is to provide a wide band gap transistor and a process for manufacturing a wide band gap transistor which allow the limitations described to be overcome or at least mitigated.

According to the present invention a wide band gap transistor and a process for manufacturing a wide band gap transistor are provided as defined in claims 1 and 6 respectively.

For a better understanding of the invention, some embodiments thereof will now be described, purely by way of non-limiting example and with reference to the attached drawings, wherein:
- Figure 1 shows a cross-section through a wide band gap transistor according to an embodiment of the present invention;
- Figure 2a shows an enlarged detail of the transistor of Figure 1 in a step of a process according to an embodiment of the present invention;

- Figure 2b shows the detail of Figure 2a in a subsequent processing step;
- Figure 2c shows the detail of Figure 2a in a subsequent processing step of a process according to a different embodiment of the present invention;
- Figure 3 shows a cross-section through a wide band gap transistor according to a different embodiment of the present invention;
- Figures 4-8 show cross-sections through a semiconductor wafer during subsequent steps of a process according to a further embodiment of the present invention;
- Figure 9 shows a cross-section through a wide band gap transistor according to a further embodiment of the present invention;
- Figure 10 shows a cross-section through a semiconductor wafer during subsequent steps of a process according to yet another embodiment of the present invention;
- Figure 11 shows a cross-section through a wide band gap transistor according to a further embodiment of the present invention;
- Figures 12-16 show cross-sections through a semiconductor wafer during subsequent steps of a process according to a further embodiment of the present invention.

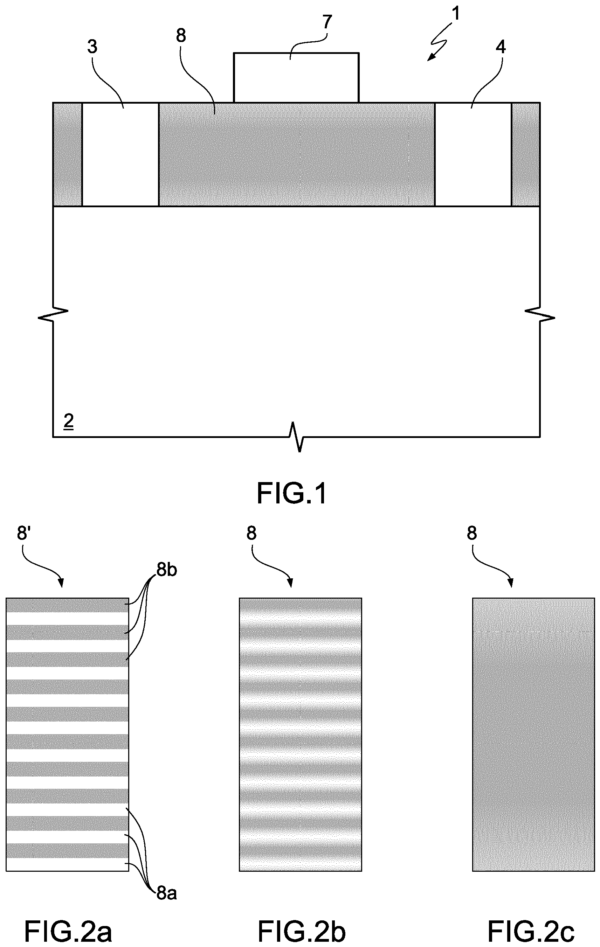

The invention relates to the manufacture of insulating gate structures in particular in wide band gap transistors. Referring to Figure 1, in general, a wide band gap transistor 1 comprises a semiconductor structure 2, wherein at least one layer is of a wide band gap semiconductor material, such as gallium nitride (GaN) or silicon carbide (SiC), a source electrode 3, a drain electrode 4 and a gate electrode 7, separated from the semiconductor structure 2 by an insulating gate structure 8. More precisely, the semiconductor structure 2 may include, in case of a GaN HEMT device, an aluminum gallium nitride (AlGaN) and GaN heterostructure - AlGaN/GaN heterostructure - or, in case of a SiC MOSFET, a SiC substrate with a high doping level (e.g. 10¹⁸ atoms/cm³ or greater) and a SiC epitaxial layer with a lower doping level (e.g. 10¹⁵-10¹⁶ atoms/cm³).

The insulating gate structure 8, illustrated in greater detail in Figures 2a-2c, contains a mixture of aluminum, hafnium and oxygen. More precisely, the insulating gate structure 8 is obtained by the conformal deposition in alternated succession of a plurality of aluminum oxide layers 8a and a plurality of hafnium oxide layers 8b having nanometer thickness to form a gate stack 8' (Figure 2a), followed by an annealing step (Figures 2b, 2c). The aluminum oxide layers 8a and the hafnium oxide layers 8b may for example have a thickness comprised between 0.5 nm and 10 nm, are amorphous and are obtained by Atomic Layer Deposition (ALD). The number of layers 8a, 8b is determined so that an overall thickness of the insulating gate structure 8 has a desired value, for example comprised between 30 nm and 60 nm. In a non-limiting embodiment, all the aluminum oxide layers 8a and the hafnium oxide layers 8b have equal thickness.

During the annealing step, aluminum oxide and hafnium oxide diffuse at the interfaces between the layers 8a, 8b and mix. Therefore, the mixture of aluminum, hafnium and oxygen is present at least at the interfaces. According to the initial thickness of the aluminum oxide layers 8a and the hafnium oxide layers 8b, the duration and the temperature of the annealing step, in the final insulating gate structure 8, the starting layered structure may be partially preserved (Figure 2b) or, alternatively, may be lost (Figure 2c). The annealing step may be carried out by heating the gate stack 8' to an annealing temperature comprised between 500 °C and 950 °C, preferably between 600 °C and 800 °C, for example 800 °C. The annealing duration may be comprised between 30 s and 600 s. The annealing temperature and the annealing duration are however selected so as to avoid crystallization of the insulating gate structure 8, owing to the diffusion and mixing of aluminum oxide and hafnium oxide. The permittivity and crystallization temperature of the insulating gate structure 8 are intermediate between the permittivity and the temperature of the aluminum oxide and those of the hafnium oxide. The insulating gate structure 8 has therefore satisfactory permittivity values and, at the same time, is capable of withstanding without structure alterations the thermal stresses that occur during the manufacturing steps of the power devices, for example for the formation of ohmic contacts. Since gate structures do not need to be protected from exposure to high temperatures, the process flow may be optimized so as to avoid unnecessary steps, for example by reducing the number of photolithographs.

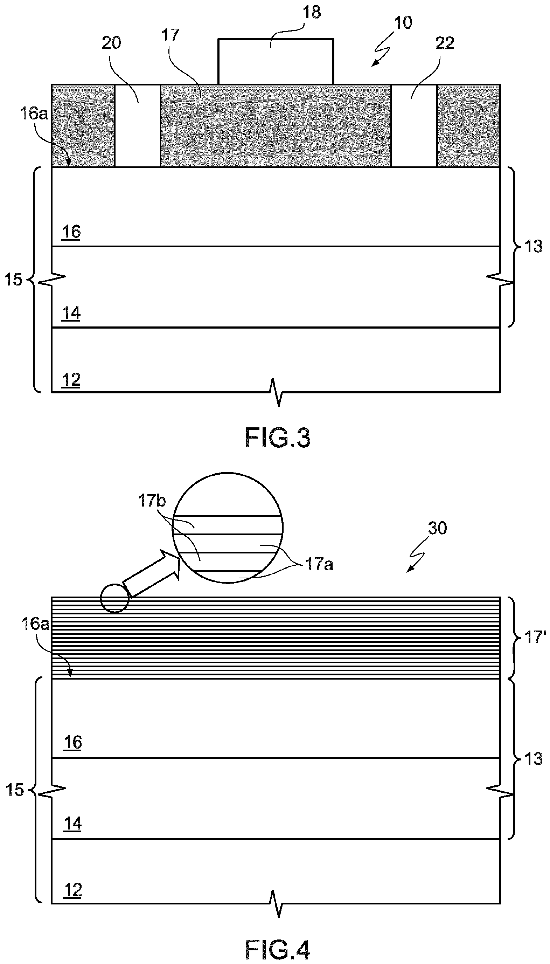

Figure 3 shows a HEMT device 10 provided with an insulating gate structure obtained as described. The HEMT device 10 includes: a substrate 12, for example of silicon, or silicon carbide (SiC) or aluminum oxide (Al₂O₃); a channel layer 14, of intrinsic gallium nitride (GaN), extending on the substrate 12; a barrier layer 16, of intrinsic aluminum gallium nitride (AlGaN) or, more generally, of compounds based on ternary or quaternary alloys of gallium nitride, such as AlₓGa₁₋ₓN, AlInGaN, InₓGa₁₋ₓN, AlₓIn₁₋ₓAl, extending on the channel layer 14; an insulating gate structure 17, extending on a face 16a of the barrier layer 16 opposite to the channel layer 14; a gate electrode 18 extending on the insulating gate structure 17 between a source electrode 20 and a drain electrode 22.

The channel layer 14 and the barrier layer 16 form a heterostructure 13 with a heterojunction 13a at the interface to each other. The heterostructure 13 extends, therefore, between a bottom side of the channel layer 14, which is part of the interface with the underlying substrate 12, and a top side 16a of the barrier layer 16.

The substrate 12, the channel layer 14 and the barrier layer 16 are hereinafter referred to, as a whole, as semiconductor structure 15. An active region 13a, defined in the semiconductor structure 15, accommodates, in use, the conductive channel of the HEMT device 10. In the embodiment of Figure 3, the gate electrode 18 extends on the insulating gate structure 17 in a zone corresponding to the active region 13a.

The insulating gate structure 17, provided as already illustrated with reference to Figures 2a-2c, contains a mixture of aluminum, hafnium and oxygen. More precisely, the insulating gate structure 17 is obtained by the conformal deposition in alternated succession of a plurality of aluminum oxide layers 17a and a plurality of hafnium oxide layers 17b having nanometer or sub-nanometer thickness, followed by an annealing step. The aluminum oxide layers 17a and the hafnium oxide layers 17b are amorphous.

According to further embodiments not shown, the semiconductor body 15 and well as the active region 13a accommodated therein, may comprise, according to the design preferences, a single layer or multiple layers of GaN, or GaN alloys, suitably doped or of an intrinsic type.

In the embodiment of Figure 3, the source 20 and drain regions 22, of conductive material, for example metal, extend exclusively through the insulating gate layer 17, until they reach the surface 16a of the barrier layer 16, without going deep into the barrier layer 16.

According to embodiments not shown, the source regions 20 and the drain regions 22 extend for a part of the thickness of the barrier layer 16, terminating inside the barrier layer 16.

According to further embodiments not shown, the source regions 20 and the drain regions 22 extend in depth into the semiconductor body 15, completely through the barrier layer 16, terminating at the interface between the barrier layer 16 and the channel layer 14.

According to further embodiments not shown, the source regions 20 and the drain regions 22 further extend partially through the channel layer 14 and terminate into the channel layer 14.

An example of a manufacturing process of the HEMT device 10 will be described below with reference to Figures 4-9.

Initially, Figure 4, a semiconductor wafer 30 comprises the substrate 12, for example of silicon or silicon carbide (SiC) or aluminum oxide (Al₂O₃). The channel layer 14, of gallium nitride (GaN), and the barrier layer 16, of aluminum gallium nitride (AlGaN), are formed on the substrate 12, extending on the channel layer 14. The barrier layer 16 and the channel layer 14 form, as previously mentioned, the heterostructure 13 and the heterojunction 13a.

A gate stack 17' is then formed, as described with reference to Figure 2a. In particular, the gate stack 17' is obtained by the conformal deposition in alternated succession of a plurality of aluminum oxide layers 17a (Al₂O₃) and a plurality of hafnium oxide layers 17b (HfO₂) having nanometer thickness, until they reach a desired overall thickness. The aluminum oxide layers 17a and the hafnium oxide layers 17b are amorphous and are formed by Atomic Layer Deposition (ALD), which ensures structure conformality and extremely accurate thickness control.

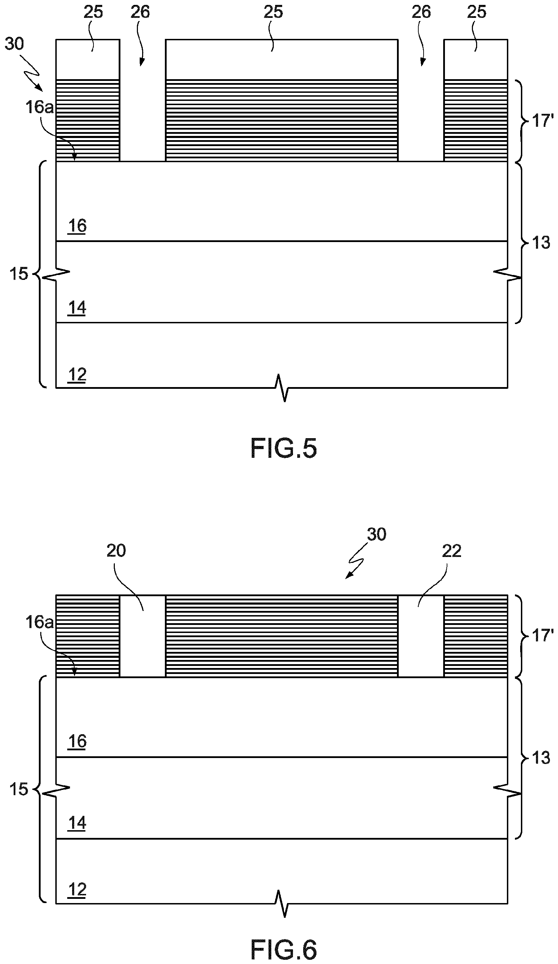

Subsequently (Figure 5), a first sacrificial layer 25, for example of resist, is formed on the gate stack 17' and defined by a first photolithographic process. The first sacrificial layer 25 has openings 26 for the formation of the source electrode 20 and of the drain electrode 22. The first sacrificial layer 25 is used as a mask to selectively etch the gate stack 17' through the openings 26.

Referring to Figure 6, following the deposition of a metal layer or multilayer and the lift-off of the first sacrificial layer 25, the source electrode 20 and the drain electrode 22 are formed in positions corresponding to respective openings 26.

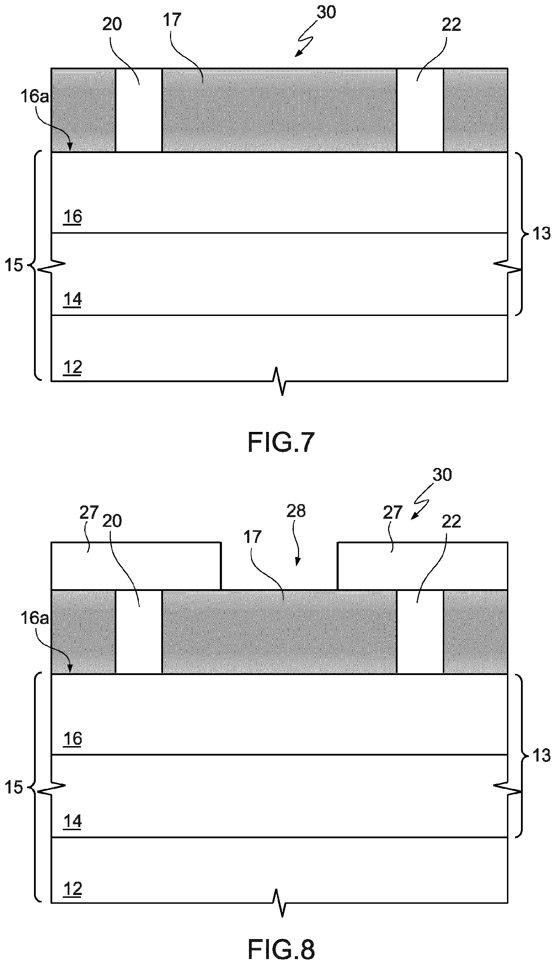

An annealing step is then performed at a temperature comprised for example between 500 °C and 950 °C, preferably between 600 °C and 800 °C, for the formation of ohmic contacts. At the same time, the aluminum oxide layers 17a and the hafnium oxide layers 17b that are adjacent diffuse into each other at the respective interfaces and the insulating gate structure 17 is formed from the residual portions of the gate stack 17', as shown in Figure 7. The number and thicknesses of the aluminum oxide layers 17a and the hafnium oxide layers 17b, the annealing temperature and the annealing duration are selected according to the design preferences so that the insulating gate structure 17 maintains (as in the example of Figure 2b) or does not maintain traces (as in the example of Figure 2c) of the starting layers 17a, 17b and crystallization is avoided.

A second sacrificial layer 27 (Figure 8) is then formed on the insulating gate structure 17, on the source electrode 20 and on the drain electrode 22 and defined by a second photolithographic process. The second sacrificial layer 27 has an opening 28 for the formation of the gate electrode 18.

Following the deposition of a metal layer or multilayer and the lift-off by plasm or wet etching of the second sacrificial layer 27, the gate electrode 18 is formed in a position corresponding to the opening 28. Optionally, a further annealing step may be performed after the deposition of the metal layer or multilayer, for example at 400 °C.

After conventional and not illustrated final processing steps and the dicing of the semiconductor wafer 30, the HEMT device 10 of Figure 3 is obtained.

The diffusion of the aluminum oxide layers 17a and the hafnium oxide layers 17b during annealing allows a high permittivity value, typically intermediate between the permittivity values of the single intrinsic Al₂O₃ and HfO₂ layers, to be maintained, while avoiding crystallization of the material during subsequent high temperature processing steps. In particular, the resistance to high temperatures advantageously allows the gate stack 17' to be formed before forming the source and drain electrodes with the respective ohmic contacts without the material being degraded. In this manner a single photolithographic process and a single annealing step may be used to both define the insulating gate structure 17 and to form the source and drain electrodes with the respective ohmic contacts.

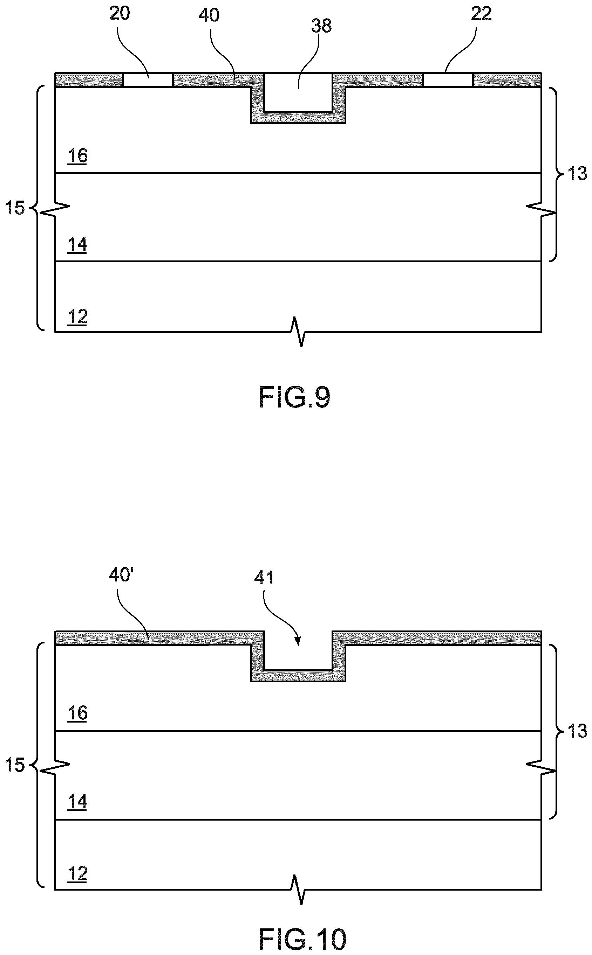

According to a different embodiment, Figure 9, the gate region, here indicated by 38, may be of a recess type and insulating gate structure 40 is not planar. In this case, the barrier layer 16 is selectively plasma etched to open a trench 41 before forming the insulating multilayer 40', which is conformally deposited by ALD (Figure 10).

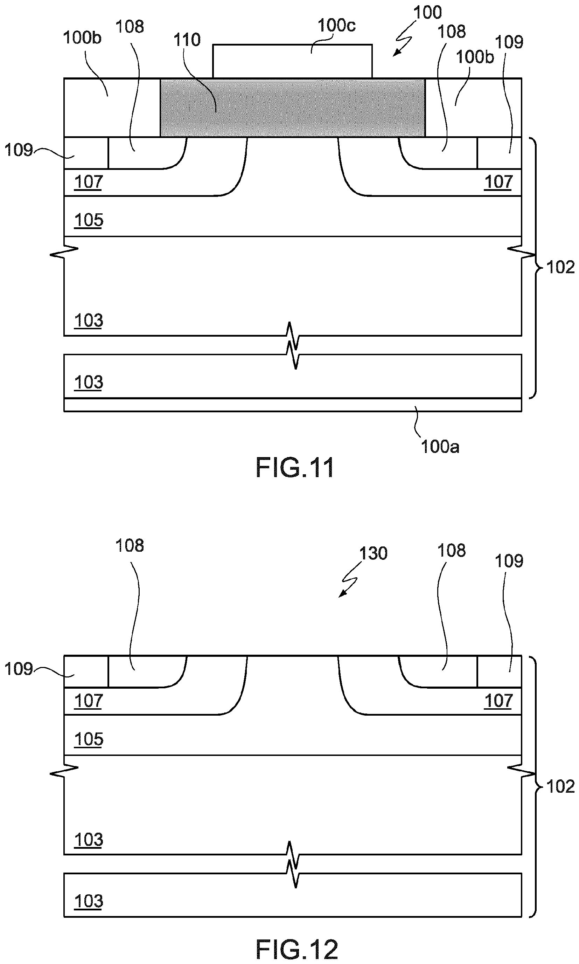

Referring to Figure 11, a vertical MOSFET 100 comprises a semiconductor structure 102 of silicon carbide (SiC), has a drain electrode 100a on a rear side 102a of the semiconductor structure 102 and source electrodes 100b and a gate electrode 100c on a front side 102b of the semiconductor structure 102. The semiconductor structure 102 in turn comprises a substrate 103 (one face whereof defines the rear side 100a) and an epitaxial layer 105 (one face whereof defines the front side 102b of the semiconductor structure 102) both having conductivities of a first type, for example of N-type. However, the N-type substrate 103 of SiC has a first doping level that is higher (e.g. 10¹⁸ atoms/cm³ or greater), while the epitaxial layer 103 has a second doping level that is lower (e.g. 10¹⁵-10¹⁶ atoms/cm³).

Body wells 107, having conductivity of a second type, here P-type, are formed inside the epitaxial layer 105 and accommodate respective source regions 108, with conductivity of the first type, in particular N+, and contact regions 109, with conductivity of the second type, in particular P+, and contiguous to respective source regions 108. The epitaxial layer 105 defines a Current Spread Layer (CSL) wherein the body wells 107 are embedded.

The body wells 107 are separated from each other by a distance normally less than 1 µm, for example 0.6 µm. The body wells 107 and the portion of the epitaxial layer 105 comprised therebetween form a parasitic JFET region.

An insulating gate structure 110 extends on the front side 102a of the semiconductor structure 102 on the epitaxial layer 105 (or on the enhancement layer 6, if any) between the source regions 108 and is surmounted by the gate electrode 100b. The insulating gate structure 110, provided as already illustrated with reference to Figures 2a-2c, contains a mixture of aluminum, hafnium and oxygen. More precisely, the insulating gate structure 110 is obtained by the conformal deposition in alternated succession of a plurality of aluminum oxide layers and a plurality of hafnium oxide layers having nanometer or sub-nanometer thickness, followed by an annealing step.

An example of a manufacturing process of the MOSFET 100 will be described below with reference to Figures 12-16.

Initially, Figure 12, a semiconductor wafer 130 comprises the substrate 103, whereon the epitaxial layer 105 is grown to form the semiconductor structure 102. The body wells 107, the source regions 108 and the contact regions 109 are then formed by subsequent ion implantations of different doping species. After the implantations, an activation annealing step is carried out at a high temperature, for example above 1600 °C.

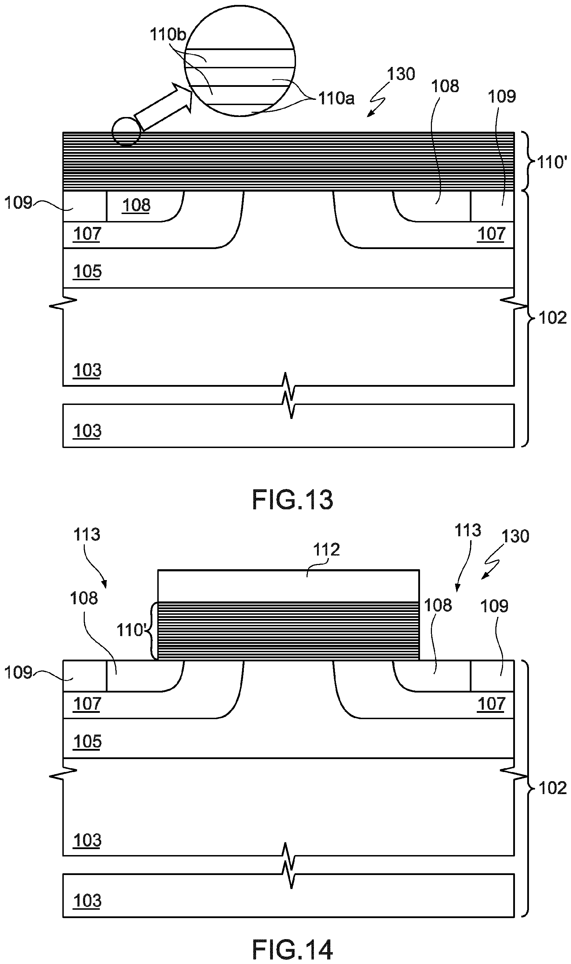

Then (Figure 13), a gate stack 110' is formed, as described with reference to Figure 2a. In particular, the gate stack 110' is obtained by the conformal deposition in alternated succession of a plurality of aluminum oxide layers 110a and a plurality of hafnium oxide layers 110b having nanometer thickness, until they reach an overall desired thickness. The aluminum oxide layers 110a and the hafnium oxide layers 17b are formed by Atomic Layer Deposition (ALD).

As shown in Figure 14, a first sacrificial layer 112 of resist is formed on the gate stack 110' and defined by a first photolithographic process. The first sacrificial layer 112 has openings 113 for the formation of the source electrodes 100b and is used as a mask to selectively etch the gate stack 110'.

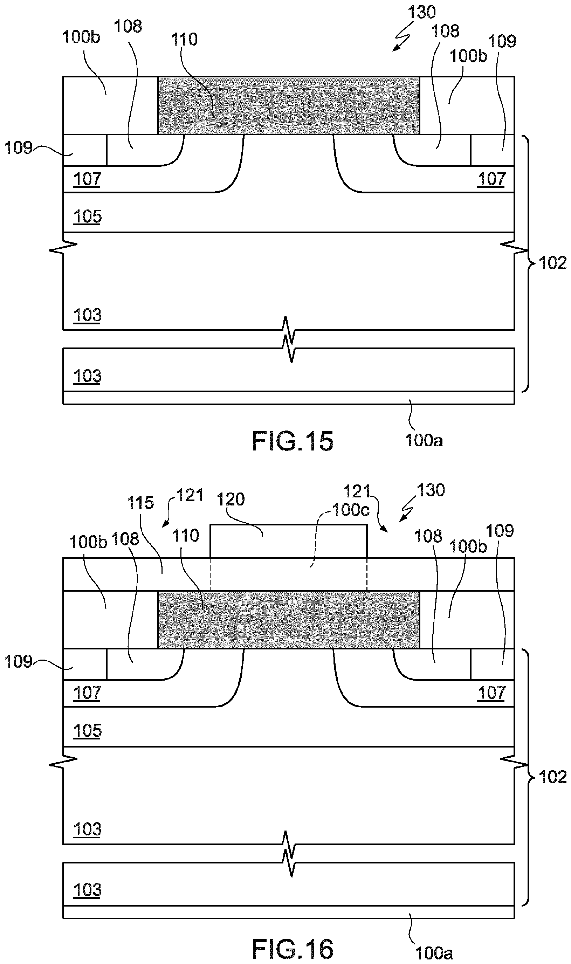

Referring to Figure 15, following the deposition of a metal layer or multilayer on the front side 102b of the semiconductor structure 102 and the lift-off of the first sacrificial layer 112, the source electrodes 100b are formed in positions corresponding to respective openings 113. Simultaneously or subsequently to the deposition on the front side 102b, a metal layer or multilayer is also deposited on the rear side 102a of the semiconductor structure 102e to form the drain electrode 100a. Before depositing the drain electrode 100a, the substrate 103 may be mechanically thinned (grinded) and possibly be subject to laser annealing.

Once the drain electrode 100a and the source electrodes 100b have been formed, an annealing step is carried out, for example at an annealing temperature of 800 °C for the formation of silicides. In this step, wherein the gate stack 110' is heated to the annealing temperature, the aluminum oxide and hafnium oxide of the layers 110a, 110b of the gate stack 110' diffuse at the interfaces and mix. Thus, at least at the interfaces, the mixture of aluminum, hafnium and oxygen is present. According to the initial thickness of the aluminum oxide layers 8 and the hafnium oxide layers 8b, the duration and the temperature of the annealing step, in the final insulating gate structure 110, the starting layered structure may be partially preserved (as in the example of Figure 2b) or, alternatively, may be lost (as in the example of Figure 2c).

After annealing (Figure 16), a metal layer or multilayer 115, of a material different from the material used for the source electrodes 100b, is deposited on the insulating gate structure 110 and on the source electrodes 100b, then a second sacrificial layer 120 of resist is formed on part of the metal layer or multilayer 115 and is defined by a second photolithographic process. The second sacrificial layer 120 has openings 121 for the formation of the gate electrodes 100c. The second sacrificial layer 120 is used as a mask to selectively etch the metal layer or multilayer 115 through the openings 121, for example by plasma etching. The gate electrode 100c is thus obtained.

After conventional and not illustrated final processing steps and the dicing of the semiconductor wafer 30, the MOSFET 100 of Figure 11 is obtained.

The insulating gate structure 117 and the manufacturing process described allow high-permittivity dielectrics to be used as gate insulators in SiC MOSFETs instead of silicon oxide, for example, with a double advantage. On the one hand, in fact, the high permittivity allows the highest electric field values to be localized within the epitaxial layer 105. It is thus possible to optimize both the thickness of the same epitaxial layer 105 and the on-state resistance RON. On the other hand, the process flow is simplified because the nitric oxide post-oxidation annealing steps at high temperature (1100 - 1200 °C) are eliminated.

Finally, it is apparent that modifications and variations may be made to the described transistor and process, without departing from the scope of the present invention, as defined in the attached claims.

## Claims

1. A wide band gap transistor comprising:
a semiconductor structure (2; 15; 102), including at least one wide band gap semiconductor layer (14, 16; 103, 105) of gallium nitride (GaN) or silicon carbide (SiC);
an insulating gate structure (8; 17; 110);
a gate electrode (7; 18; 100c), separated from the semiconductor structure (2; 15; 102) by the insulating gate structure (8; 17; 110);
wherein the insulating gate structure (8; 17; 110) contains a mixture of aluminum, hafnium and oxygen;
and wherein the insulating gate structure (8; 17; 110) is completely amorphous.

2. The transistor according to claim 1, wherein the semiconductor structure (15) comprises a heterostructure (13) including a channel layer (14) of gallium nitride (GaN) and a barrier layer (16) of a material selected in the group consisting of: aluminum gallium nitride (AlGaN), ternary alloys of aluminum and gallium or quaternary alloys of aluminum and gallium; a heterojunction (13a) being formed at an interface between the channel layer (14) and the barrier layer (16).

3. The transistor according to claim 1, wherein the semiconductor structure (102) comprises:
a substrate (103) of silicon carbide (SiC) having a conductivity of a type and a first doping level;
and an epitaxial layer (105) of silicon carbide (SiC) having conductivity of said type and a second doping level lower than the first doping level.

4. The transistor according to any of claims 1 to 3, wherein the insulating gate structure (8; 17; 110) is at least partially layered in a plurality of first regions (2a; 17a) containing aluminum oxide (Al₂O₃) and a plurality of second containing regions (2b; 17b) of hafnium oxide (HfO₂) that are alternated with the first regions (2a; 17a).

5. The transistor according to claim 4, wherein the first regions (2a; 17a) and the second containing regions (2b; 17b) have a thickness comprised between 1 nm and 5 nm.

6. A process for manufacturing a wide band gap transistor, comprising:
forming a semiconductor structure (2; 15; 102), including at least one wide band gap semiconductor layer (14, 16; 103, 105) of gallium nitride (GaN) or silicon carbide (SiC);
forming an insulating gate structure (8; 17; 110) on the semiconductor structure (2; 15; 102);
forming a gate electrode (7; 18; 100c) on the insulating gate structure (8; 17; 110);
wherein the insulating gate structure (8; 17; 110) contains a mixture of aluminum, hafnium and oxygen;
and wherein the insulating gate structure (8; 17; 110) is completely amorphous.

7. The process according to claim 6, wherein forming the semiconductor structure (2; 15; 102) comprises:
forming a heterostructure (13) including a channel layer (14) of gallium nitride (GaN) and a barrier layer (16) of aluminum gallium nitride (AlGaN), a heterojunction (13a) being formed at an interface between the channel layer (14) and the barrier layer (16).

8. The process according to claim 6, wherein forming the semiconductor structure (102) comprises:
forming a substrate (103) of silicon carbide (SiC) having a conductivity of a type and a first doping level; and
forming an epitaxial layer (105) of silicon carbide (SiC) having conductivity of said type and a second doping level lower than the first doping level.

9. The process according to any of claims 6 to 8, wherein forming the insulating gate structure (8; 17; 110) comprises:
depositing in alternated succession a plurality of aluminum oxide layers (8a; 17a; 110a) and a plurality of hafnium oxide layers (8b; 17b; 110b), forming a gate stack (8'; 17'; 110'); and
performing an annealing so that the aluminum oxide of the aluminum oxide layers (8a; 17a; 110a) and the hafnium oxide of the hafnium oxide layers (8b; 17b; 110b) diffuse at interfaces between adjacent aluminum oxide layers (8a; 17a; 110a) and hafnium oxide layers (8b; 17b; 110b) and mix.

10. The process according to claim 9, wherein performing an annealing comprises heating the gate stack (8'; 17'; 110') to an annealing temperature for an annealing duration and wherein the annealing temperature and the annealing duration are selected so as to prevent the insulating gate structure (8; 17; 110) from crystallizing.

11. The process according to claim 9 or 10, wherein the temperature is comprised between 500 °C and 950 °C, preferably between 600 °C and 800 °C, and the annealing duration is comprised between 30 s and 600 s.

12. The process according to any of claims 9 to 11, wherein depositing in succession comprises depositing by Atomic Layer Deposition (ALD).

13. The process according to any of claims 9 to 12, wherein the aluminum oxide layers (8a; 17a; 110a) and the hafnium oxide layers (8b; 17b; 110b) have a thickness comprised between 0.5 nm and 10 nm.

14. The process according to any of claims 9 to 13, comprising forming at least one source electrode (3; 20; 100b) and a drain electrode (4; 20; 100a), after forming the gate stack (8'; 17'; 110').

## Patentansprüche

1. Transistor mit großer Bandlücke, umfassend:
eine Halbleiterstruktur (2; 15; 102), die mindestens eine Halbleiterschicht mit großer Bandlücke (14, 16; 103, 105) aus Galliumnitrid (GaN) oder Siliziumcarbid (SiC) enthält; eine isolierende Gate-Struktur (8; 17; 110);
eine Gate-Elektrode (7; 18; 100c), die durch die isolierende Gate-Struktur (8; 17; 110) von der Halbleiterstruktur (2; 15; 102) getrennt ist;
wobei die isolierende Gate-Struktur (8; 17; 110) eine Mischung aus Aluminium, Hafnium und Sauerstoff beinhaltet; und wobei die isolierende Gate-Struktur (8; 17; 110) vollständig amorph ist.

2. Transistor nach Anspruch 1, wobei die Halbleiterstruktur (15) eine Heterostruktur (13) umfasst, die eine Kanalschicht (14) aus Galliumnitrid (GaN) enthält und eine Sperrschicht (16) aus einem Material, das ausgewählt ist aus der Gruppe, die besteht aus: Aluminiumgalliumnitrid (AlGaN), ternären Legierungen von Aluminium und Gallium oder quaternären Legierungen von Aluminium und Gallium; und einen Heteroübergang (13a), der an einer Grenzfläche zwischen der Kanalschicht (14) und der Sperrschicht (16) gebildet ist.

3. Transistor nach Anspruch 1, wobei die Halbleiterstruktur (102) umfasst:
ein Substrat (103) aus Siliziumcarbid (SiC), das die Leitfähigkeit eines Typs und einen ersten Dotierungsgrad aufweist;
und eine Epitaxieschicht (105) aus Siliziumcarbid (SiC), das die Leitfähigkeit jenes Typs aufweist, und einen zweiten Dotierungsgrad, der tiefer als der erste Dotierungsgrad ist.

4. Transistor nach einem der Ansprüche 1 bis 3, wobei die isolierende Gate-Struktur (8; 17; 110) mindestens teilweise in einer Vielzahl von ersten Bereichen (2a; 17a) geschichtet ist, die Aluminiumoxid (Al₂O₃) beinhalten, und einer Vielzahl von zweiten Bereichen (2b; 17b), die Hafniumoxid (HfO₂) beinhalten, und sich mit den ersten Bereichen (2a; 17a) abwechseln.

5. Transistor nach Anspruch 4, wobei die ersten Bereiche (2a; 17a) und die zweiten beinhaltenden Bereiche (2b; 17b) eine Dicke zwischen 1 nm und 5 nm aufweisen.

6. Verfahren zur Herstellung eines Transistors mit großer Bandlücke, umfassend:
Bilden einer Halbleiterstruktur (2; 15; 102), die mindestens eine Halbleiterschicht mit großer Bandlücke (14, 16; 103, 105) aus Galliumnitrid (GaN) oder Siliziumcarbid (SiC) enthält;
Bilden einer isolierenden Gate-Struktur (8; 17; 110) auf der Halbleiterstruktur (2; 15; 102);
Bilden einer Gate-Elektrode (7; 18; 100c) auf der isolierenden Gate-Struktur (8; 17; 110);
wobei die isolierende Gate-Struktur (8; 17; 110) eine Mischung aus Aluminium, Hafnium und Sauerstoff beinhaltet; und wobei die isolierende Gate-Struktur (8; 17; 110) vollständig amorph ist.

7. Verfahren nach Anspruch 6, wobei das Bilden der Halbleiterstruktur (2; 15; 102) umfasst:
Bilden einer Heterostruktur, (13) die eine Kanalschicht (14) aus Galliumnitrid (GaN) und eine Sperrschicht (16) aus Aluminiumgalliumnitrid (AlGaN) enthält, wobei ein Heteroübergang (13a) an einer Grenzfläche zwischen der Kanalschicht (14) und der Sperrschicht (16) gebildet wird.

8. Verfahren nach Anspruch 6, wobei das Bilden der Halbleiterstruktur (102) umfasst:
Bilden eines Substrats (103) aus Siliziumcarbid (SiC), das eine Leitfähigkeit eines Typs und einen ersten Dotierungsgrad aufweist; und
Bilden einer Epitaxieschicht (105) aus Siliziumcarbid (SiC), das die Leitfähigkeit jenes Typs aufweist, und einen zweiten Dotierungsgrad, der tiefer als der erste Dotierungsgrad ist.

9. Verfahren nach einem der Ansprüche 6 bis 8, wobei das Bilden der isolierenden Gate-Struktur (8; 17; 110) umfasst:
abwechselndes aufeinanderfolgendes Abscheiden einer Vielzahl von Aluminiumoxidschichten (8a; 17a; 110a) und einer Vielzahl von Hafniumoxidschichten (8b; 17b; 110b), die einen Gate-Stapel bilden (8'; 17'; 110'); und
Durchführen eines Glühens, so dass das Aluminiumoxid der Aluminiumoxidschichten (8a; 17a; 110a) und das Hafniumoxid der Hafniumoxidschichten (8b; 17b; 110b) an Grenzflächen zwischen angrenzenden Aluminiumoxidschichten (8a; 17a; 110a) und Hafniumoxidschichten (8b; 17b; 110b) diffundieren und sich vermischen.

10. Verfahren nach Anspruch 9, wobei das Durchführen eines Glühens das Erwärmen des Gate-Stapels (8'; 17'; 110') auf eine Glühtemperatur für eine Glühdauer umfasst, und wobei die Glühtemperatur und die Glühdauer so gewählt sind, dass ein Kristallisieren der isolierenden Gate-Struktur (8; 17; 110) verhindert wird.

11. Verfahren nach Anspruch 9 oder 10, wobei die Temperatur zwischen 500 °C und 950 °C liegt, vorzugsweise zwischen 600 °C und 800 °C, und die Glühdauer zwischen 30 s und 600 s liegt.

12. Verfahren nach einem der Ansprüche 9 bis 11, wobei das aufeinanderfolgende Abscheiden das Abscheiden durch Atomlagenabscheidung (ALD) umfasst.

13. Verfahren nach einem der Ansprüche 9 bis 12, wobei die Aluminiumoxidschichten (8a; 17a; 110a) und die Hafniumoxidschichten (8b; 17b; 110b) eine Dicke zwischen 0,5 nm und 10 nm aufweisen.

14. Verfahren nach einem der Ansprüche 9 bis 13, das Bilden mindestens einer Source-Elektrode (3; 20; 100b) und einer Drain-Elektrode (4; 20; 100a) nach dem Bilden des Gate-Stapels (8'; 17'; 110') umfassend.

## Revendications

1. Transistor à large bande interdite comprenant :
une structure de semiconducteur (2 ; 15 ; 102) comportant au moins une couche de semiconducteur à large bande interdite (14, 16 ; 103, 105) en nitrure de gallium (GaN) ou en carbure de silicium (SiC) ;
une structure de grille isolante (8 ; 17 ; 110) ;
une électrode de grille (7 ; 18 ; 100c) séparée de la structure de semiconducteur (2 ; 15 ; 102) par la structure de grille isolante (8 ; 17 ; 110) ;
dans lequel la structure de grille isolante (8 ; 17 ; 110) contient un mélange d'aluminium, d'hafnium et d'oxygène ;
et dans lequel la structure de grille isolante (8 ; 17 ; 110) est entièrement amorphe.

2. Transistor selon la revendication 1, dans lequel la structure de semiconducteur (15) comprend une hétérostructure (13) comportant une couche de canal (14) en nitrure de gallium (GaN) et une couche de barrière (16) faite d'un matériau choisi dans le groupe comprenant : le nitrure d'aluminium et de gallium (AlGaN), les alliages ternaires d'aluminium et de gallium ou les alliages quaternaires d'aluminium et de gallium ; une hétérojonction (13a) étant formée au niveau d'une interface entre la couche de canal (14) et la couche de barrière (16).

3. Transistor selon la revendication 1, dans lequel la structure de semiconducteur (102) comprend :
un substrat (103) en carbure de silicium (SiC) ayant un type de conductivité et un premier niveau de dopage ;
et une couche épitaxiale (105) en carbure de silicium (SiC) ayant ledit type de conductivité et un deuxième niveau de dopage inférieur au premier niveau de dopage.

4. Transistor selon l'une quelconque des revendications 1 à 3, dans lequel la structure de grille isolante (8 ; 17 ; 110) est au moins partiellement stratifiée en une pluralité de premières régions (2a ; 17a) contenant de l'oxyde d'aluminium (Al₂O₃) et une pluralité de deuxièmes régions de rétention (2b ; 17b) en oxyde d'hafnium (HfO₂) qui alternent avec les premières régions (2a ; 17a).

5. Transistor selon la revendication 4, dans lequel les premières régions (2a ; 17a) et les deuxièmes régions de rétention (2b ; 17b) ont une épaisseur comprise entre 1 nm et 5 nm.

6. Procédé de fabrication d'un transistor à large bande interdite comprenant les étapes suivantes :
former une structure de semiconducteur (2 ; 15 ; 102) comportant au moins une couche de semiconducteur à large bande interdite (14, 16 ; 103, 105) en nitrure de gallium (GaN) ou en carbure de silicium (SiC) ;
former une structure de grille isolante (8 ; 17 ; 110) sur la structure de semiconducteur (2 ; 15 ; 102) ;
former une électrode de grille (7 ; 18 ; 100c) sur la structure de grille isolante (8 ; 17 ; 110) ;
dans lequel la structure de grille isolante (8 ; 17 ; 110) contient un mélange d'aluminium, d'hafnium et d'oxygène ;
et dans lequel la structure de grille isolante (8 ; 17 ; 110) est entièrement amorphe.

7. Procédé selon la revendication 6, dans lequel la formation de la structure de semiconducteur (2 ; 15 ; 102) comprend l'étape suivante :
former une hétérostructure (13) comportant une couche de canal (14) en nitrure de gallium (GaN) et une couche de barrière (16) en nitrure d'aluminium et de gallium (AlGaN), une hétérojonction (13a) étant formée au niveau d'une interface entre la couche de canal (14) et la couche de barrière (16).

8. Procédé selon la revendication 6, dans lequel la formation de la structure de semiconducteur (102) comprend les étapes suivantes :
former un substrat (103) en carbure de silicium (SiC) ayant un type de conductivité et un premier niveau de dopage ; et
former une couche épitaxiale (105) en carbure de silicium (SiC) ayant ledit type de conductivité et un deuxième niveau de dopage inférieur au premier niveau de dopage.

9. Procédé selon l'une quelconque des revendications 6 à 8, dans lequel la formation de la structure de grille isolante (8 ; 17 ; 110) comprend les étapes suivantes :
déposer en succession alternée une pluralité de couches d'oxyde d'aluminium (8a ; 17a ; 110a) et une pluralité de couches d'oxyde d'hafnium (8b ; 17b ; 110b) formant un empilement de grille (8' ; 17' ; 110') ; et
réaliser un recuit afin que l'oxyde d'aluminium des couches d'oxyde d'aluminium (8a; 17a ; 110a) et l'oxyde d'hafnium des couches d'oxyde d'hafnium (8b ; 17b ; 110b) se diffusent aux interfaces entre les couches d'oxyde d'aluminium (8a ; 17a ; 110a) et les couches d'oxyde d'hafnium (8b ; 17b ; 110b) voisines et se mélangent.

10. Procédé selon la revendication 9, dans lequel la réalisation d'un recuit comprend le chauffage de l'empilement de grille (8' ; 17' ; 110') à une température de recuit pendant une durée de recuit, et dans lequel la température de recuit et la durée de recuit sont choisies de manière à empêcher la cristallisation de la structure de grille isolante (8 ; 17 ; 110).

11. Procédé selon la revendication 9 ou 10, dans lequel la température est comprise entre 500 °C et 950 °C, de préférence entre 600 °C et 800 °C, et la durée de recuit est comprise entre 30 s et 600 s.

12. Procédé selon l'une quelconque des revendications 9 à 11, dans lequel le dépôt en succession comprend l'emploi de la technique de dépôt de couches atomiques (ALD).

13. Procédé selon l'une quelconque des revendications 9 à 12, dans lequel les couches d'oxyde d'aluminium (8a ; 17a ; 110a) et les couches d'oxyde d'hafnium (8b ; 17b ; 110b) ont une épaisseur comprise entre 0,5 nm et 10 nm.

14. Procédé selon l'une quelconque des revendications 9 à 13, comprenant la formation d'au moins une électrode de source (3 ; 20 ; 100b) et une électrode de drain (4 ; 20 ; 100a), après la formation de l'empilement de grille (8' ; 17' ; 110').
